# EUROPÄISCHE PATENTSCHRIFT

(11) **EP 4 010 711 B1**
(45) Veröffentlichungstag und Bekanntmachung des Hinweises auf die Patenterteilung: **06.09.2023**
(21) Anmeldenummer: 20754201.0
(22) Anmeldetag: 05.08.2020
(51) Int. Cl.: G01R 1/04

(54) **MASSENVERBINDUNGSSYSTEM FÜR EIN TESTSYSTEM**
MASS CONNECTION SYSTEM FOR A TEST SYSTEM
SYSTÈME DE CONNEXION DE MASSE POUR SYSTÈME D'ESSAI

(30) Priorität: 08.08.2019 DE 202019104377 U
(43) Veröffentlichungstag der Anmeldung: 15.06.2022
(73) Patentinhaber: Seipolt, Günter, 92439 Bodenwöhr (DE)
(72) Erfinder: SEIPOLT, Günter, 81925 München (DE)
(74) Vertreter: Diehl & Partner
(86) Internationale Anmeldenummer: PCT/EP2020/072047
(87) Internationale Veröffentlichungsnummer: WO 2021/023790

(56) Entgegenhaltungen:
- EP-A1- 1 245 962
- WO-A1-2012/106513
- US-A- 5 103 378
- US-A1- 2007 248 217
- US-A1- 2009 223 712
- US-A1- 2017 003 722
- Xcerra: "VG Series -FAQ Mass Interconnect Products", , 1. Juni 2018 (2018-06-01), XP055749844, Gefunden im Internet: URL:https://ect-cpg.com/wp-content/uploads /2018/06/VG-FAQ-NEW.pdf [gefunden am 2020-11-12]
- Vpc: "TEST & MEASUREMENT - Mass InterConnect Solutions", , 2. Juni 2015 (2015-06-02), XP055748593, Gefunden im Internet: URL:https://www.massinterconnect.de/files/ content-media/40-support/01-public-downdlo ads/VPC/vpc_full_gross.pdf [gefunden am 2020-11-09]

## Beschreibung

Die vorliegende Erfindung betrifft ein Massenverbindungssystem für ein Testsystem, um eine Vielzahl (Masse) von Verbindungen zwischen einem oder mehreren Testgeräten und einer oder mehreren zu testenden Platinen/Einheiten herzustellen. Bei dem Testsystem kann es sich beispielsweise um ein In-Circuit-Testsystem, welches insbesondere Leitungen auf bestückten Platinen prüft, oder um ein Funktionstestsystem, welches die ordnungsgemäße Funktion der Komponenten überprüft, handeln.

Konkret werden Massenverbindungssysteme zwischen einem Interchangeable Test Adapter (Prüfadapter) und einem Messinstrument angeordnet.

Der Interchangeable Test Adapter kontaktiert beispielsweise für einen in-circuit test eine zu testende Platine über Testnadeln oder für einen Funktionstest Ein- und Ausgänge einer fertigen Einheit. Je nach Prüfobjekt weist der Interchangeable Test Adapter einige zehn bis einige hundert Ein- und Ausgänge auf.

Bei dem Messinstrument handelt es sich um ein technisches Gerät, welches dazu in der Lage ist, eine integrierte Schaltung oder eine fertige Einheiten und damit einen Prüfling zu analysieren und so elektronisch auf ihre Funktionalität und Integrität zu überprüfen. Hierfür sendet das Messinstrument Signale an den Prüfling und empfängt eine Reaktion von dem Prüfling. Messinstrument sind typischerweise plattformbasiert aufgebaut. Derzeit geläufige Plattformen sind PCI eXtensions for Instrumentation (PXI-Standard), VME eXtensions for Instrumentation (VXI-Standard), LAN eXtensions for Instrumentation (LXI-Standard) oder auch der GPIB-Standard, der SCXI-Standard, und der PCI-Standard.

Aufgabe des Massenverbindungssystems ist es, gleichzeitig und schnell eine zuverlässige Verbindung zwischen allen Ein- und Ausgängen eines verwendeten Interchangeable Test Adapter zu allen Ein- und Ausgängen eines verwendeten Messinstrument herzustellen. Diese Flexibilität ist gewünscht, um die in der Regel hochpreisigen Messinstrumente mit unterschiedlichen Interchangeable Test Adapter verbinden zu können.

Offenbart wird vorliegend auch ein System bestehend aus einem Interchangeable Test Adapter wie vorstehend beschrieben und einem mit diesem über ein Massenverbindungssystem verbundenes Messinstrument wie vorstehend beschrieben.

Bei Testsystemen wird an einer zu testenden Platine/Einheit beispielsweise unter Verwendung von Prüfstiften/Testadaptern eine Vielzahl von Messgrößen abgegriffen. Die zu testende Platine/Einheit bildet zusammen mit den Prüfstiften/dem Testadapter eine zu prüfende Seite. Diese Messgrößen müssen dann dem eigentlichen Testgerät zugeführt werden, welches eine Prüferseite bildet. Die Gesamtheit aus zu prüfender Seite und Prüferseite wird als Testsystem oder Prüfstand bezeichnet. Die auf der Prüferseite verwendeten Testgeräte weisen üblicherweise unterschiedliche Bussysteme mit einer sehr großen Zahl an Ein- und Ausgängen auf (üblicherweise zwischen 200 und 5.000), die in der Regel nicht alle gleichzeitig für einen jeweiligen Einsatzzweck benötigt werden, aber eine universale Verwendbarkeit des jeweiligen Testgerätes sicherstellen. Häufig sind die Testgeräte zudem modular aufgebaut, so dass eine weitere Anpassung an den jeweiligen Einsatzzweck möglich ist.

Da die verwendeten Testgeräte sehr teuer sind, findet normalerweise keine feste Verdrahtung zwischen der zu prüfenden Seite und der Prüferseite statt; vielmehr wird die Verbindung zwischen der zu prüfenden Seite und der Prüferseite üblicherweise über Massenverbindungssysteme hergestellt, die an einen jeweiligen Einsatzzweck angepasst sind. Das Massenverbindungssystem stellt zum einen eine Schnittstelle zwischen unterschiedlichen Kontaktträgern auf der zu prüfenden Seite und der Prüferseite dar. Weiter reduziert das Massenverbindungssystem die Anzahl der Verbindungen auf ein benötigtes Maß. Ein erstes Massenverbindungssystem ist auf der zu prüfenden Seite und ein zu dem ersten Massenverbindungssystem komplementäres zweites Massenverbindungssystem ist auf der Prüferseite vorgesehen. Gemeinsam erlauben das erste und zweite Massenverbindungssystem eine schnelle lösbare elektrische, pneumatische und/oder optische Verbindung der zu prüfenden Seite mit der Prüferseite.

Herkömmlicherweise werden derartige Massenverbindungssysteme dadurch bereitgestellt, dass eine massive Blende mit Öffnungen vorgesehen ist, in welche Kontaktträger, die zur Herstellung einer Verbindung benötigt werden, eingesetzt sind. Die Halterung der Kontaktträger erfolgt zumeist durch Verschrauben oder Klemmen.

Geht ein Kontaktträger kaputt (zum Beispiel aufgrund von Verschleiß), wird die Befestigung des entsprechenden Kontaktträgers gelöst und dieser nach vorn aus der Blende herausgezogen. Damit dies möglich ist, muss eine Verdrahtung des Kontaktträgers hinter der Blende (welche Verdrahtung hin zum Testgerät (auf der Prüferseite) bzw. den Prüfstiften oder dem Testadapter (auf der zu prüfenden Seite) führt) ausreichend Spielraum bereitstellen. Ersichtlich ist die Herstellung und Wartung von herkömmlichen Massenverbindungssystemen sehr aufwendig.

Die Merkmale des Oberbegriffes von Anspruch 1 sind aus dem Dokument US 2007/0248217 A1 und der Internet-Veröffentlichung "VG Series-FAQ Mass Interconnect Products" (https://ect-cpg.com/wp-content/uploads/2018/06/VG-FAO-NEW.pdt) beschrieben.

Weitere Massenverbindungssysteme werden in den Dokumenten EP 1 245 962 A1, US 2009/0223712 A1, der Internet-Veröffentlichung "TEST & MEASUREMENT - Mass InterConnect Solutions" (https://www.massinterconnect.de/files/content-media/40-support/01-public-downdloads/VPC/vpc full gross.pdf) und dem Patent US 5,103,378 bekannt.

Ausgehend hiervon ist es daher Aufgabe der vorliegenden Erfindung, ein Massenverbindungssystem für ein Testsystem bereitzustellen, welches leicht hergestellt, gewartet und umgerüstet werden kann.

Die vorstehende Aufgabe wird durch die Kombination der Merkmale des unabhängigen Anspruchs 1 gelöst. Bevorzugte Weiterbildungen finden sich in den Unteransprüchen.

Ausführungsformen eines Massenverbindungssystems für ein Testsystem weisen einen Aufnahmerahmen und wenigstens einen Trägerrahmen(-Einschub) auf. Der Aufnahmerahmen, der insgesamt beispielsweise die Form einer rechteckigen Platte aufweisen kann, besitzt mehrere Ausnehmungen, welche den Aufnahmerahmen in Dickenrichtung jeweils vollständig durchdringen und zu einer Einschubkante des Aufnahmerahmens hin jeweils offen sind. Die Einschubkante des Aufnahmerahmens ist somit diejenige Seitenkante des Aufnahmerahmens, zu der hin die Ausnehmungen offen sind. Dabei legt jede Ausnehmung zwei zueinander parallele Seitenwände fest, die mit der Einschubkante jeweils einen Winkel von zwischen 60° und 120° und bevorzugt 90° einschließen. Jeder Trägerrahmen weist zwei zueinander parallele Seitenwände auf, welche dazu ausgebildet sind, mit den parallelen Seitenwänden einer jeden Ausnehmung des Aufnahmerahmens in Formschluss zu kommen. Dieser Formschluss verhindert eine Bewegung des Trägerrahmens senkrecht zu einer vom Aufnahmerahmen festgelegen Fläche. Somit kann in jede Ausnehmung im Aufnahmerahmen ausgehend von der Einschubkante wenigstens ein Trägerrahmen eingeschoben oder in Richtung der Einschubkante aus der jeweiligen Ausnehmung entfernt werden. Dabei dienen die zueinander parallelen Seitenwänden einer jeden Ausnehmung als Führungsschienen für die zueinander parallelen Seitenwände eines jeden Trägerrahmens. Wenigstens ein Trägerrahmen weist weiter eine Öffnung zur Aufnahme wenigstens eines Kontaktträgers auf. Hierfür weist die Öffnung eine Innenkontur auf, die an eine Außenkontur des wenigstens einen Kontaktträgers angepasst ist.

Gemäß einer Ausführungsform erlaubt der Formschluss zwischen dem Aufnahmerahmen und dem wenigstens einen Trägerrahmen eine schwimmende Bewegung des Trägerrahmens relativ zum Aufnahmerahmen, um durch das so verbleibende kleine Spiel zwischen Trägerrahmen und Aufnahmerahmen eine genaue Zentrierung des Trägerrahmens bei Verbindung des Massenverbindungssystems mit einem anderen Massenverbindungssystem des Testsystems zu erlauben. Hierdurch wird eine mechanische Belastung des wenigstens einen Kontaktträgers reduziert.

Anders als im Stand der Technik, in dem die Blenden von Massenverbindungssystemen für ein Testsystem individuell an verwendete Kontaktträger angepasst werden müssen oder lediglich zur Aufnahme von Kontaktträgern eines einzigen Herstellers geeignet sind, muss bei dem erfindungsgemäßen Massenverbindungssystem für ein Testsystem nur die Öffnung im Trägerrahmen an einen jeweiligen Kontaktträger angepasst werden. Anders formuliert dienen die Trägerrahmen als Adapterrahmen für die Kontaktträger. Es ist dann nur noch erforderlich, eine Auswahl an Trägerrahmen bereitzustellen, die jeweils Öffnungen aufweisen, die an Kontaktträger der jeweiligen Hersteller angepasst sind. Dies erlaubt es, ein Massenverbindungssystem mit mehreren durch die Ausnehmungen im Aufnahmerahmen gebildeten einheitlichen Aufnahmen für Trägerrahmen bereitzustellen, welche Trägerrahmen dann Kontaktträger beliebiger Hersteller sowie selbst hergestellte Kontaktträger aufnehmen können. Einzige Bedingung hierfür ist, dass die Trägerrahmen und damit die Ausnehmungen im Aufnahmerahmen groß genug dimensioniert sind, um den größten verwendeten Kontaktträger zu haltern. Optional kann die Ausnehmung im Aufnahmerahmen auch so dimensioniert sein, dass sie den größten Kontaktträger direkt, d.h. ohne Trägerrahmen haltern kann. In der Folge kann das Massenverbindungssystem leicht und kostengünstig hergestellt und flexibel verwendet werden. Die Trägerrahmen mit den gehalterten Kontaktträger können so leicht entnommen und umgesetzt werden.

Da die Trägerrahmen mit den Kontaktträgern zudem zur Seite (nach rechts, links, oben und/oder unten) hin und nicht - wie im Stand der Technik üblich nach vorn aus dem Aufnahmerahmen entnommen werden können, ist eine Wartung und Umrüstung sowie ein Austausch eines von einem Trägerrahmen gehalterten Kontaktträgers leichter möglich, da für eine Entnahme zur Seite ein geringes Spiel einer den Kontaktträger kontaktierenden Leitung ausreichend ist. Auch wenn die in die Ausnehmungen des Aufnahmerahmens eingesetzten Trägerrahmen Kontaktträger haltern ist es daher möglich, die Konfiguration des Massenverbindungssystems je nach Bedarf zu ändern. Es ist so beispielsweise möglich mit Kontaktträgern vorkonfigurierte Trägerrahmen bereit zu stellen, die dann bei einem Wechsel des Testgerätes, mit welchem das Massenverbindungssystem verwendet werden soll, ebenfalls ausgetauscht werden. Ein solcher Wechsel des Testgerätes kommt in der Praxis häufig vor, da die Kosten der in Testsystemen verwendeten Komponenten erheblich sind, und diese daher gut ausgelastet werden sollen. Häufig sind die Testgeräte für "plug-and-play" ausgebildet.

Es wird betont, dass zwar alle Trägerrahmen Öffnungen zur Aufnahme wenigstens eines Kontaktträgers aufweisen können, dies aber nicht zwingend erforderlich ist. Alternativ können auch Trägerrahmen verwendet werden, die frei von Öffnungen sind, und so als Blindabdeckung dienen können. Weiter kann jede Ausnehmung im Aufnahmerahmen genau einen oder mehr als einen Trägerrahmen aufnehmen.

Weiter wird betont, dass es sich bei dem Trägerrahmen zwar um ein einfaches platten-, rahmen-, u-förmiges oder käfigförmiges Element handeln kann, das vorliegende Dokument hierauf aber nicht beschränkt ist. Alternativ kann auch innerhalb des Trägerrahmens eine Verdrahtung erfolgen, und der Trägerrahmen somit die Form eines kleinen Gehäuses aufweisen. In diesem Fall wird der Trägerrahmen von der Öffnung für den Kontaktträger nicht vollständig durchsetzt.

Erfindungsgemäß weisen alle Ausnehmungen im Aufnahmerahmen die gleiche Innenkontur auf und weisen auch alle Trägerrahmen die gleiche Außenkontur auf. Weiter ist die Außenkontur aller Trägerrahmen zumindest abschnittsweise komplementär zur Innenkontur aller Ausnehmungen im Aufnahmerahmen. Auf diese Weise ist sichergestellt, dass jeder Trägerrahmen in eine beliebige Ausnehmung im Aufnahmerahmen eingeschoben werden kann.

Weiter weist der wenigstens eine Trägerrahmen an wenigstens einer Schmalseite ein vom Trägerrahmen lösbares Element aufweist, welches es erlaubt, die Öffnung des wenigstens einen Trägerrahmens zu einer Schmalseite des Trägerrahmens hin zu öffnen, um ein Einschieben eines Kontaktträgers zu erlauben. Alternativ kann die Öffnung des wenigstens einen Trägerrahmens hin zu einer Schmalseite des Trägerrahmens auch einfach offen sein und so das Einschieben eines Kontaktträgers ermöglichen.

Gemäß einer Ausführungsform weisen einander gegenüberliegende und zueinander parallele die Öffnung des wenigstens einen Trägerrahmens begrenzende Wände des Trägerrahmens eine Kontur auf, die ausgebildet ist, mit einer Außenkontur wenigstens eines in der Öffnung aufzunehmenden Kontaktträgers in Formschluss zu kommen. Somit kann die Kontur der die Öffnung begrenzenden Wände des wenigstens einen Trägerrahmens komplementär zur Außenkontur wenigstens eines in der Öffnung aufzunehmenden Kontaktträgers sein. Eine entsprechende Kontur erleichtert das Einschieben des Kontaktträgers in die Öffnung des wenigstens einen Trägerrahmens.

Gemäß einer Ausführungsform unterscheidet sich die Form der Kontur der die Öffnung des wenigstens einen Trägerrahmens begrenzenden Flächen von der Außenkontur der Trägerrahmen.

Gemäß einer Ausführungsform weist wenigstens eine Seitenwand der zueinander parallelen Seitenwände jeder Ausnehmung im Aufnahmerahmen wenigstens einen Vorsprung auf und weist wenigstens eine Seitenwand der zueinander parallelen Seitenwände jedes Trägerrahmens wenigstens einen zum wenigstens einen Vorsprung komplementären Rücksprung auf. Alternativ oder zusätzlich weist wenigstens eine Seitenwand der zueinander parallelen Seitenwände jeder Ausnehmung im Aufnahmerahmen wenigstens einen Rücksprung auf und weist wenigstens eine Seitenwand der zueinander parallelen Seitenwände jedes Trägerrahmens wenigstens einen zum wenigstens einen Rücksprung komplementären Vorsprung auf.

Eine solche Anpassung der Innenkontur der Ausnehmungen an die Außenkontur der Trägerrahmen erlaubt es, die Trägerrahmen so an den Aufnahmerahmen anzupassen, dass eine von den Trägerrahmen festgelegte Fläche mit einer vom Aufnahmerahmen festgelegten Fläche fluchtet.

Gemäß einer Ausführungsform weisen einander gegenüberliegende und zueinander parallele die Öffnung des wenigstens einen Trägerrahmens begrenzende Wände des Trägerrahmens wenigstens einen Vorsprung auf und weist wenigstens eine Seitenwand des Kontaktträgers wenigstens einen zum wenigstens einen Vorsprung komplementären Rücksprung auf. Alternativ oder zusätzlich weisen einander gegenüberliegende und zueinander parallele die Öffnung des wenigstens einen Trägerrahmens begrenzende Wände des Trägerrahmens wenigstens einen Rücksprung auf und weist wenigstens eine Seitenwand des Kontaktträgers wenigstens einen zum wenigstens einen Rücksprung komplementären Vorsprung auf.

Eine solche Anpassung erlaubt es, Kontaktträger in die Öffnung im Trägerrahmen einzuschieben und dort sicher zu haltern.

Gemäß einer Ausführungsform ist jeder Trägerrahmen ausgebildet, eine jede der Ausnehmungen im Aufnahmerahmen zu 100 % oder zu 75 % oder zu 66 % oder zu 50 % oder zu 33 % oder zu 25 % oder zu 20 % auszufüllen. Bei einer solchen Anpassung der Größe jedes Trägerrahmens an die Größe der Ausnehmungen im Aufnahmerahmen kann jede Ausnehmung im Aufnahmerahmen zwischen einem einzigen Trägerrahmen und fünf zueinander benachbarten Trägerrahmen aufnehmen. Die von einer Ausnehmung im Aufnahmerahmen aufgenommenen Trägerrahmen können auch unterschiedlich groß sein. Auf diese Weise können in derselben Ausnehmung im Aufnahmerahmen beispielsweise auch Trägerrahmen, die an Steckverbindungen unterschiedlicher Hersteller angepasst sind, eingeschoben werden.

Gemäß einer Ausführungsform weisen die beiden zueinander parallelen Seitenwände jeder Ausnehmung und die beiden zueinander parallelen Seitenwände jedes Trägerrahmens im Querschnitt voneinander paarweise unterschiedliche Konturen auf. Auf diese Weise kann sichergestellt werden, dass die Trägerrahmen nur mit einer vorgegebenen Orientierung in die Ausnehmungen im Aufnahmerahmen eingesetzt werden können.

Gemäß einer Ausführungsform weist wenigstens ein Trägerrahmen einen Rahmen aus vier paarweise zueinander parallelen Körpern auf, welche an ihrer Außenseite jeweils die Seiten des Trägerrahmens bilden und an ihrer Innenseite jeweils die Öffnung zur Aufnahme wenigstens eines Kontaktträgers festlegen.

Gemäß einer Ausführungsform sind dann die Körper, welche die Seiten des Trägerrahmens bilden, stabförmig ausgebildet, und sind die Körper, welche die Oberseite und Unterseite des Trägerrahmens bilden, plattenförmig ausgebildet. Dann sind die plattenförmigen Körper jeweils mit den beiden stabförmigen Körpern lösbar verbunden. In der Folge bilden die Körper einen zerlegbaren Rahmen zur Aufnahme des wenigstens einen Kontaktträgers.

Gemäß einer Ausführungsform wird dabei unter einem plattenförmigen Körper ein Körper verstanden, der eine kürzeste Seitenkante aufweist, deren Länge weniger als 1/5 der Länge der nächstkürzesten Seitenkante beträgt. Weiter wird gemäß einer Ausführungsform unter einem stabförmigen Körper ein Körper verstanden, der eine kürzeste Seitenkante aufweist, deren Länge wenigstens 1/4 der Länge der nächstkürzesten Seitenkante beträgt, und bei dem die Länge der längsten Seitenkante wenigstens das Doppelte der zweitlängsten Seitenkante beträgt.

Gemäß einer Ausführungsform weisen die beiden stabförmigen Körper an ihrer der Öffnung zugewandten Seite jeweils eine Kontur auf, die ausgebildet ist, mit einer Außenkontur wenigstens eines in der Öffnung aufzunehmenden Kontaktträgers in Formschluss zu kommen. In der Folge können in geöffnetem Zustand des Rahmens die Kontaktträger einfach in den von den Körpern gebildeten Rahmen eingeschoben werden, und werden die Kontaktträger nach Schließen des Rahmens sicher im Rahmen gehaltert.

Gemäß einer Ausführungsform weisen der Aufnahmerahmen und/oder der wenigstens eine Trägerrahmen wenigstens zwei Zentriermittel auf, welche geeignet sind, mit entsprechenden Gegenstücken in Eingriff zu kommen und den Aufnahmerahmen und/oder den wenigstens einen Trägerrahmen zu zentrieren. Bei den Zentriermitteln kann es sich beispielsweise um Zentrierpins oder Zentrierbohrungen oder eine Kombination von beiden handeln. Die Zentriermittel können auch dazu verwendet werden, mit Kontaktträgern versehene Trägerrahmen eineindeutig zu kennzeichnen und so einen verwechslungsfreien Austausch der Trägerrahmen zu erlauben. Hierfür muss die Anordnung der Zentriermittel für einen jeweiligen mit Kontaktträgern versehenen Trägerrahmen charakteristisch sein. Entsprechend darf die Anordnung der Zentriermittel nur bei Trägerrahmen gleich sein, welche die gleichen Kontaktträger haltern und somit austauschbar sind.

Gemäß einer Ausführungsform weist wenigstens ein Trägerrahmen wenigstens einen RFID-Chip auf, in welchem eine eindeutige Kennung des Trägerrahmens und/oder eine Kennung des vom Trägerrahmen aufgenommenen wenigstens einen Kontaktträger gespeichert ist. Dies erleichtert eine Logistik der Trägerrahmen.

Gemäß einer Ausführungsform weist das Massenverbindungssystem weiter einen Deckel auf, der ausgebildet ist, so an der Einschubkante des Aufnahmerahmens mit dem Aufnahmerahmen verbunden zu werden, dass er die Ausnehmungen im Aufnahmerahmen hin zur Einschubkante verschließt. Somit ist der wenigstens eine Trägerrahmen bei geschlossenem Deckel gegen eine Entnahme aus der Ausnehmung im Aufnahmerahmen gesichert. Wenn die Öffnung des wenigstens einen Trägerrahmens hin zu einer Schmalseite des Trägerrahmens offen ist, kann der Deckel auch die Öffnung im Trägerrahmen verschließen und so einen in der Öffnung im Trägerrahmen gehalterten Kontaktträger sichern.

Gemäß einer Ausführungsform weist der Deckel eine der Anzahl an Ausnehmungen im Aufnahmerahmen entsprechende Anzahl an Federelementen auf, wobei die Federelemente voneinander den gleichen Abstand aufweisen, wie die Ausnehmungen im Aufnahmerahmen. Die Federelemente, bei denen es sich beispielsweise um Blattfedern oder in Bohrungen im Deckel eingesetzte konische Federn handeln kann, erlauben es, bei mit dem Aufnahmerahmen verbundenem Deckel einen Druck auf in die Ausnehmungen im Aufnahmerahmen eingesetzte Trägerrahmen oder (wenn die Öffnung des wenigstens einen Trägerrahmens hin zu einer Schmalseite des Trägerrahmens offen ist) auf die in die Öffnung im Trägerrahmen eingesetzten Kontaktträger auszuüben. Dann können die Federelemente gemäß einer Ausführungsform bei mit dem Aufnahmerahmen verbundenem Deckel jeweils mittig zu einer Ausnehmung im Aufnahmerahmen angeordnet sein.

Gemäß einer Ausführungsform weisen die Ausnehmungen des Aufnahmerahmens jeweils wenigstens ein Federelement auf, das ausgebildet ist, den wenigstens einen Trägerrahmen lösbar innerhalb der dem jeweiligen Federelement zugeordneten Ausnehmung zu haltern. Bevorzugt setzen die Federelemente dabei den jeweiligen Trägerrahmen in eine Richtung hin zu einem Boden der Ausnehmung unter Vorspannung. Die Federelemente können beispielsweise oberhalb der Trägerrahmen benachbart zum Deckel am Aufnahmerahmen vorgesehen sein und in Richtung der Ausnehmung vorspringen. Alternativ oder zusätzlich können die Federelemente im oberen, mittleren oder unteren Bereich der Trägerrahmen am Aufnahmerahmen vorgesehen sein und in Richtung der Ausnehmung vorspringen. In diesem Fall können die Federelemente mit an den Trägerrahmen ausgebildeten Vor- oder Rücksprüngen in Eingriff kommen.

Gemäß einer Ausführungsform weist das Massenverbindungssystem weiter wenigstens einen Kontaktträger auf. Dabei ist jeder Kontaktträger dazu ausgebildet, Leitungen für technische Medien zu verbinden oder zu trennen. Bei den Leitungen kann es sich insbesondere um elektrische Leitungen und/oder Leitungen für optische Strahlung handeln. Insbesondere kann jeder Kontaktträger ein Einbaustecker oder eine Buchse sein.

Gemäß einer Ausführungsform weist jeder Trägerrahmen, der eine Öffnung zur Aufnahme wenigstens einen Kontaktträgers aufweist, Befestigungsmittel zur Halterung des jeweiligen Kontaktträgers auf. Bei diesen Befestigungsmitteln kann es sich beispielsweise um Schraubgewinde, Drehriegel oder auch um Kanten, die mit Klemmfedern oder einer Außenkontur eines jeweiligen Kontaktträgers in Eingriff kommen, handeln.

Gemäß einer Ausführungsform ist der Deckel durch Verschrauben oder mittels einer Schnappverbindung lösbar an dem Aufnahmerahmen befestigbar. Beispielsweise kann der Deckel an seinen beiden Enden zwei Durchgänge für Schrauben aufweisen, mit denen der Deckel mit dem Aufnahmerahmen verschraubt werden kann. Zur Erleichterung der Handhabbarkeit können für die Schrauben Rändelschrauben verwendet werden.

Gemäß einer Ausführungsform sind die Ausnehmungen in regelmäßigen Abständen voneinander im Aufnahmerahmen angeordnet. Beispielsweise kann ein Abstand zwischen benachbarten Ausnehmungen jeweils 5 mm oder jeweils 8 mm oder jeweils 10 mm betragen.

Gemäß einer Ausführungsform weist das Massenverbindungssystem weiter ein Gehäuse auf, welches einseitig von dem Aufnahmerahmen und dem Deckel verschlossen ist, und eine Verdrahtung für wenigstens einen Kontaktträger aufnimmt.

Gemäß einer Ausführungsform handelt es sich bei dem Aufnahmerahmen und/oder dem Deckel und/oder jedem Trägerrahmen jeweils um eine massive Platte aus Kunststoff oder Metall. Gemäß einer Ausführungsform sind der Aufnahmerahmen und der Deckel und jeder Trägerrahmen aus dem gleichen Material gebildet. Gemäß einer alternativen Ausführungsform sind der Aufnahmerahmen und der Deckel aus einem ersten Material gebildet und ist jeder Trägerrahmen aus einem von dem ersten Material verschiedenen zweiten Material gebildet. Gemäß einer Ausführungsform sind der Aufnahmerahmen und/oder der Deckel und/oder jeder Trägerrahmen aus einem elektrisch leitfähigen Material gebildet, welches im Betrieb des Massenverbindungssystems geerdet ist. Gemäß einer alternativen Ausführungsform sind der Aufnahmerahmen und/oder der Deckel und/oder jeder Trägerrahmen aus einem nicht elektrisch leitfähigen Material gebildet. Gemäß einer Ausführungsform werden alle Ausnehmungen des Aufnahmerahmens von einem geerdeten Metallrahmen umgeben, der einen Schutz gegen mechanische oder elektromagnetische Beeinträchtigungen bietet. Optional können die Trägerrahmen durch spanabhebende Verfahren oder durch 3D-Druck-Verfahren oder durch Spritzguss hergestellt sein.

Gemäß einer Ausführungsform sind alle Ausnehmungen im Aufnahmerahmen zur selben Einschubkante des Aufnahmerahmens hin offen. Gemäß einer Ausführungsform weist der Aufnahmerahmen mehr als eine Einschubkante auf.

Weitere Merkmale der Erfindung ergeben sich aus der nachfolgenden Beschreibung von Ausführungsbeispielen in Verbindung mit den Ansprüchen sowie den Figuren. In den Figuren werden gleiche bzw. ähnliche Elemente mit gleichen bzw. ähnlichen Bezugszeichen bezeichnet. Es wird darauf hingewiesen, dass die Erfindung nicht auf die Ausführungsformen der beschriebenen Ausführungsbeispiele beschränkt, sondern durch den Umfang der beiliegenden Patentansprüche bestimmt ist. Insbesondere können die einzelnen Merkmale bei erfindungsgemäßen Ausführungsformen in anderer Anzahl und Kombination als bei den untenstehend angeführten Beispielen verwirklicht sein. Bei der nachfolgenden Erläuterung eines Ausführungsbeispiels der Erfindung wird auf die beiliegenden Figuren Bezug genommen, von denen
- Figur 1A: schematisch eine Ansicht von vorn auf ein Massenverbindungssystem zeigt, wobei nur zwei Ausnehmungen im Aufnahmerahmen mit Trägerrahmen bestückt sind, und der Deckel mit dem Aufnahmerahmen verschraubt ist;
- Figur 1B: schematisch eine Ansicht von links auf das Massenverbindungssystem aus Figur 1A zeigt;
- Figur 1C: schematisch eine Ansicht von rechts auf das Massenverbindungssystem aus Figur 1A zeigt, wobei die Ansicht vergrößert und teilweise freigeschnitten ist;
- Figur 2A: schematisch eine Ansicht von oben auf den Deckel des Massenverbindungssystem aus Figur 1A zeigt, wobei der Deckel von dem Aufnahmerahmen gelöst ist;
- Figur 2B: schematisch eine Ansicht von unten auf den Deckel aus Figur 2A zeigt;
- Figur 3: schematisch eine Ansicht von vorn auf einen Trägerrahmen des Massenverbindungssystem aus Figur 1A zeigt, wobei der Trägerrahmen nicht mit einem Kontaktträger bestückt ist;
- Figuren 4A bis 4C: schematisch Querschnitte parallel zur Einschubkante durch unterschiedliche Aufnahmerahmen und von dem Aufnahmerahmen aufgenommene Trägerrahmen zeigen, wobei die Querschnitte so gelegt sind, dass sie Öffnungen der Trägerrahmen nicht schneiden;
- Figur 5A: schematisch eine Ansicht von vorn auf einen teilweise zusammengebauten rahmenförmigen Aufnahmerahmen zeigt;
- Figur 5B: schematisch einen Schnitt durch Figur 5A zeigt; und
- Figur 6: schematisch eine Ansicht von vorn auf einen u-förmigen Aufnahmerahmen zeigt.

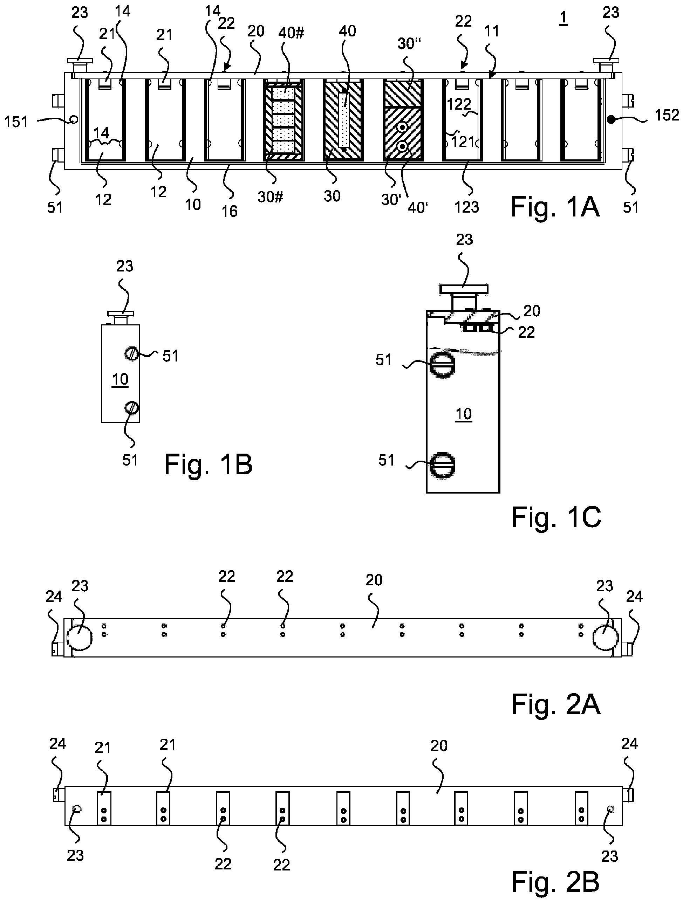

Im Folgenden wird unter Bezugnahme auf die Figuren 1 bis 3 eine Ausführungsform eines Massenverbindungssystems für ein Testsystem beschrieben. Es wird betont, dass dieses Massenverbindungssystem sowohl an der zu prüfenden Seite als auch der Prüferseite eines Testsystems vorgesehen sein kann.

Wie gut aus den Figuren 1A bis 1C ersichtlich, weist das Massenverbindungssystem 1 einen Aufnahmerahmen 10, einen Deckel 20 und mehrere Trägerrahmen 30, 30', 30", 30# auf. In der gezeigten Ausführungsform sind der Aufnahmerahmen 10, der Deckel 20 und die Trägerrahmen 30, 30', 30", 30# aus massivem Aluminium gebildet.

Der Aufnahmerahmen 10 ist von seiner Grundform her ein länglicher Quader mit einer Länge von 48,26 Zentimetern (≙ 19 Zoll) und einer Höhe von 133,35 Millimetern (≙ 5,25 Zoll). Damit ist der Aufnahmerahmen 10 so dimensioniert, dass er von einem Baugruppenträger der 19"-Bauweise aufgenommen werden kann. Die Tiefe/Dicke des Aufnahmerahmens beträgt in der gezeigten Ausführungsform 2 cm. Über eine Zentrierbohrung 151 und einen Zentrierpin 152 ist eine Zentrierung mit dem Aufnahmerahmen eines anderen (nicht gezeigten) Massenverbindungssystems möglich (sofern dieses über eine Zentrierbohrung und einen Zentrierpin verfügt, die komplementär angeordnet sind).

Wie gut aus Figur 1A ersichtlich, weist der Aufnahmerahmen 10 neun insgesamt U-förmige Ausnehmungen 12 auf, welche den Aufnahmerahmen 10 in Dickenrichtung jeweils vollständig durchdringen und zu einer Einschubkante 11 des Aufnahmerahmens 10 hin jeweils offen sind. In Figur 1A wird die Einschubkante 11 von dem Deckel 20 abgedeckt, welcher über zwei Rändelschrauben 23 mit dem Aufnahmerahmen 10 verschraubt ist.

Jede der Ausnehmungen 12 weist zwei zueinander parallele Seitenwände 121, 122 und eine zu diesen senkrechte Unterkante 123 auf. Die zueinander parallelen Seitenwände 121, 122 schließen mit der Einschubkante 11 jeweils einen Winkel von 90° ein.

In die Ausnehmungen 12 sind Trägerrahmen 30, 30', 30", 30# schwimmend, das heißt mit geringem Spiel, eingesetzt.

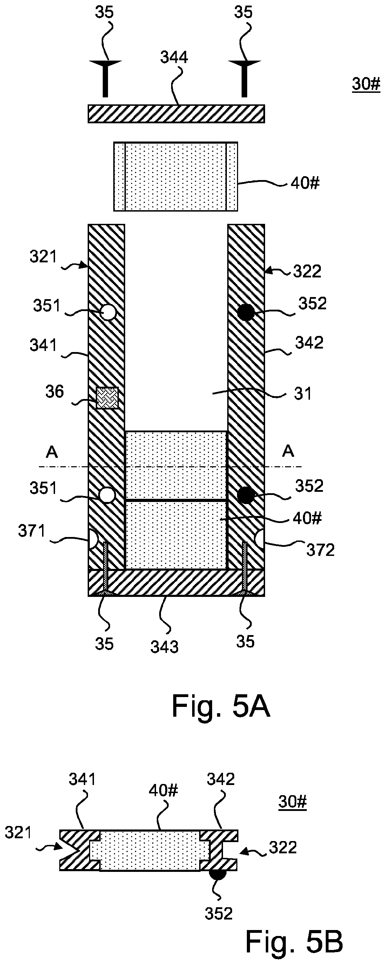

Weiter weisen die Ausnehmungen 12 benachbart zum Deckel 20 jeweils zwei Federelemente 14 auf, welche in die Ausnehmungen 12 eingesetzte Trägerrahmen 30, 30', 30", 30# lösbar haltern und in Richtung hin zur Unterkante 123 der Ausnehmung 12 unter Vorspannung setzen. Weitere zwei Federelemente 14 sind im unteren Bereich der Ausnehmungen 12 vorgesehen und setzen die Trägerrahmen 30, 30', 30", 30# seitlich unter Druck. Die Federelemente 14 können dabei auch mit entsprechenden Vertiefungen 371, 372 in den Trägerrahmen 30# in Eingriff kommen (die Vertiefungen 371, 372 sind in Figur 5A gezeigt).

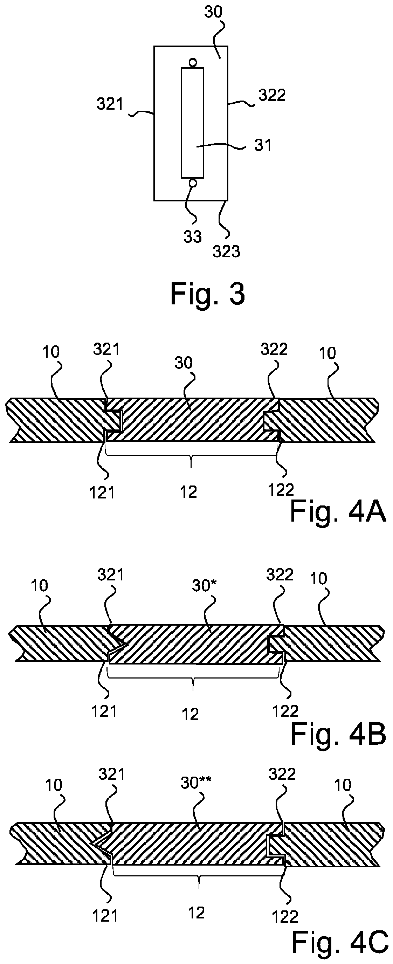

Wie gut aus Figur 3, 4, 5 und 6 ersichtlich, weist auch jeder Trägerrahmen 30, 30', 30", 30# zwei zueinander parallele Seitenwände 131, 132 auf.

Alle Ausnehmungen 12 des Aufnahmerahmens 10 insgesamt werden von einem vorspringenden und geerdeten Metallrahmen 16 umgeben, der mit dem Deckel 20 fluchtet, ca. 0,5 cm vorspringt und eine Abschirmung der Trägerrahmen 30, 30`, 30", 30# gegen mechanische Beschädigung und elektromagnetische Strahlung bewirkt.

In den Figuren 4A bis 4C sind schematisch Querschnitte parallel zur Einschubkante durch eine Ausnehmung 12 des Aufnahmerahmens 10 und einen von der Ausnehmung 12 aufgenommenen Trägerrahmen 30, 30* und 30** gezeigt. Ersichtlich sind die beiden zueinander parallelen Seitenwände 131, 132 jedes Trägerrahmens 30, 30*, 30** so ausgebildet, dass sie mit den parallelen Seitenwänden 121, 122 einer jeden Ausnehmung 12 des Aufnahmerahmens 10 in Formschluss kommen, wenn der Trägerrahmen 30, 30*, 30** über die Einschubkante 11 in eine jeweilige Ausnehmung 12 des Aufnahmerahmens 10 eingeführt wird. Ersichtlich zeigen die Figuren 4A, 4B und 4C unterschiedliche Ausnehmungen 12 und Trägerrahmen 30, 30*, 30**, die nicht alle gleichzeitig im selben Massenverbindungssystem verwirklicht sein müssen.

Wie in der Figur 4A gezeigt, können die zueinander parallelen Seitenwände 121, 122 jeder Ausnehmung 12 im Aufnahmerahmen 10 beispielsweise einen Vorsprung aufweisen und die beiden zueinander parallelen Seitenwände 131, 132 jedes Trägerrahmens 30 einen zum Vorsprung komplementären Rücksprung aufweisen. In Figur 4A sind die Vorsprünge an den zueinander parallelen Seitenwänden 121, 122 jeder Ausnehmung 12 symmetrisch aufgebaut, so dass der Trägerrahmen 30 mit einer beliebigen Orientierung in die Ausnehmung eingesetzt werden kann.

Alternativ ist es jedoch auch möglich, die Vorsprünge an den zueinander parallelen Seitenwänden 121, 122 jeder Ausnehmung 12 unsymmetrisch auszubilden, so dass der Trägerrahmen 30* nur mit einer vorgegebenen Orientierung in die Ausnehmung 12 eingesetzt werden kann, wie es in Figur 4B und 4C gezeigt ist.

In den Figuren 4A und 4B weisen die zueinander parallelen Seitenwände 121, 122 jeder Ausnehmung 12 jeweils Vorsprünge und die zueinander parallelen Seitenwände 131, 132 jedes Trägerrahmens 30, 30^{∗} jeweils zu den Vorsprüngen komplementäre Rücksprünge auf. Alternativ kann aber auch an einer Seitenwand 321 des Trägerrahmens 30^{∗∗} ein Vorsprung und an der zugehörigen Seitenwand 122 der Ausnehmung 12 des Aufnahmerahmens 10 ein komplementärer Rücksprung vorgesehen sein, wie es in Figur 4C gezeigt ist.

Damit alle Trägerrahmen 30, 30' und 30" flexibel in alle Ausnehmung 12 im Aufnahmerahmen 10 eingesetzt werden können, weisen alle Ausnehmungen 12 im Aufnahmerahmen 10 des in Figur 1A gezeigten Massenverbindungssystems 1 die gleiche Innenkontur und alle Trägerrahmen 30, 30', 30", 30# die gleiche Außenkontur auf (alle Ausnehmungen 12 und Trägerrahmen 30, 30', 30", 30# weisen beispielsweise eine der Konturen der Figuren 4A oder 4B oder 4C auf).

Dabei kann der Trägerrahmen 30, 30# so dimensioniert sein, dass er eine ihn aufnehmende Ausnehmung 12 vollständig ausfüllt. Alternativ kann der Trägerrahmen 30', 30" auch so dimensioniert sein, dass er eine ihn aufnehmende Ausnehmung 12 nur teilweise ausfüllt. In der gezeigten Ausführungsform füllt der Trägerrahmen 30` die ihn aufnehmende Ausnehmung 12 zu 2/3 und füllt der Trägerrahmen 30" die ihn aufnehmende Ausnehmung 12 zu 1/3 aus. Auch wenn in Figur 1A nicht in alle Ausnehmungen 12 ein Trägerrahmen 30, 30', 30", 30# eingesetzt ist, so sollten im Betrieb alle Ausnehmungen vollständig mit Trägerrahmen 30, 30', 30", 30# gefüllt sein.

Wie aus Figur 3 ersichtlich, weist der dort gezeigte insgesamt plattenförmige Trägerrahmen 30 eine rechteckige Öffnung 31 zur Aufnahme eines in Figur 1A gezeigten Kontaktträgers 40 mit rechteckigem Querschnitt auf. Weiter weist der Trägerrahmen 30 Befestigungsmittel in Form zweier Gewindelöcher 33 auf, mittels derer der Kontaktträger 40 am Trägerrahmen 30 befestigt werden kann. Entsprechend weist der in Figur 1A gezeigte insgesamt plattenförmige Trägerrahmen 30' zwei runde Öffnungen für Kontaktträger 40` mit rundem Querschnitt auf. Der weitere in Figur 1A gezeigte insgesamt plattenförmige Trägerrahmen 30" weist keine Öffnung für einen Kontaktträger auf und dient somit als Blindabdeckung. Der weitere in Figur 1A gezeigte insgesamt rahmenförmige Trägerrahmen 30# wird nachfolgend detailliert erläutert werden.

Wie gut aus den Figuren 2A und 2B ersichtlich, weist der Deckel 20 an seiner Unterseite eine Vielzahl von Blattfedern 21 auf, die über Schrauben 22 mit dem Deckel 20 verbunden sind. Die Blattfedern 21 sind dabei so angeordnet, dass sie bei mit dem Aufnahmerahmen 10 verbundenem Deckel 20 jeweils mittig zu einer Ausnehmung 12 im Aufnahmerahmen 10 angeordnet sind und von der jeweiligen Ausnehmung 12 aufgenommene Trägerrahmen 30, 30', 30", 30# unter Druck setzen.

Der Deckel 20 weist weiter zwei Vorsprünge 24 auf, welche mit entsprechenden Rücksprüngen im Aufnahmerahmen 10 in Eingriff kommen und den Deckel 20 so gegenüber dem Aufnahmerahmen 10 zentrieren.

Weiter weist der Aufnahmerahmen Schrauben 51 auf, welche eine Befestigung des Aufnahmerahmens in einem Gehäuse oder Rack ermöglichen. Das Gehäuse und eine vom Gehäuse aufgenommene Verdrahtung der Kontaktträger 40, 40` ist in den Figuren nicht gezeigt.

In den Figuren 5A und 5B ist der Aufbau des insgesamt rahmenförmigen Trägerrahmens 30# detailliert gezeigt. Dabei zeigt Figur 5A eine Ansicht von vorn auf den teilweise zusammengebauten Trägerrahmen 30# und Figur 5B eine Schnittansicht entlang der Schnittlinie A-A von Figur 5A.

Ersichtlich weist der Trägerrahmen 30# zwei zueinander parallele stabförmige Körper 341 und 342 auf, welche mittels Schrauben 35 mit zwei zueinander parallelen plattenförmigen Körpern 343 und 344 so verbunden sind, dass die Körper 341, 342, 343 und 344 insgesamt einen rechtwinkligen Rahmen bilden, der eine Öffnung 31 zur Aufnahme wenigstens eines Kontaktträgers 40# festlegt.

Wie gut aus Figur 5A ersichtlich, weisen die zueinander parallelen stabförmigen Körper 341 und 342 jeweils ein Paar von Zentrierbohrungen 351 bzw. Zentrierpins 532 auf, wobei die Zentrierbohrungen 351 und Zentrierpins 532 paarweise zueinander komplementär ausgebildet und angeordnet sind. Bei Verbindung des Massenverbindungssystems 1 mit einem anderen (nicht gezeigten) Massenverbindungssystem, welches entsprechende Trägerrahmen aufweist, erlauben die Zentrierbohrungen 351 und Zentrierpins 532 eine genaue Ausrichtung der schwimmend vom Aufnahmerahmen aufgenommenen Trägerrahmen zueinander und reduzieren so eine mechanische Belastung der Kontaktträger.

Wie gut aus Figur 5B ersichtlich, weisen die beiden stabförmigen Körper 341, 342 an ihrer der Öffnung 31 zugewandten Seite jeweils eine Kontur auf, die ausgebildet ist, mit einer Außenkontur wenigstens eines in der Öffnung aufzunehmenden Kontaktträgers 40# in Formschluss zu kommen. In der Folge können in zumindest einseitig geöffnetem Zustand des Rahmens die Kontaktträger 40# einfach in den von den stabförmigen Körper 341, 342 sowie dem unteren plattenförmigen Körper 343 gebildeten Rahmen eingeschoben werden, und werden die Kontaktträger 40# nach Schließen des Rahmens mittels des oberen plattenförmigen Körpers 344 sicher gehaltert.

Aus Figur 5B ist auch ersichtlich, dass sich die Kontur der die Öffnung 31 eines oder jedes Trägerrahmens 30# begrenzenden Wände (welche den aufzunehmenden Kontaktträgern 40# zugewandt sind) von der den zueinander parallelen Seitenwänden 121, 122 jeder Ausnehmung 12 zugewandten Außenkontur der zueinander parallelen Seitenwände eines oder jedes Trägerrahmens 30# unterscheidet. Vielmehr ist die Kontur der die Öffnung 31 begrenzenden Wände komplementär zu einer Außenkontur der Kontaktträger 40#. Auf diese Weise ist es mittels des Trägerrahmens 30# möglich, Kontaktträger 40# in einer Ausnehmung 12 des Aufnahmerahmens 10 anzuordnen, obwohl die Außenkontur der Kontaktträger 40# nicht zur Innenkontur der Ausnehmungen 12 des Aufnahmerahmens 10 passt.

An einem der stabförmigen Körper 341 ist ein RFID-Chip 35 vorgesehen, in welchem eine eindeutige Kennung des Trägerrahmens 30# und eine Kennung der vom Trägerrahmen 30# aufgenommenen Kontaktträger 40# gespeichert ist.

Es wird darauf hingewiesen, dass die unteren Schrauben 35 in Figur 5A nur zum besseren Verständnis gezeigt, aber eigentlich nicht sichtbar sind.

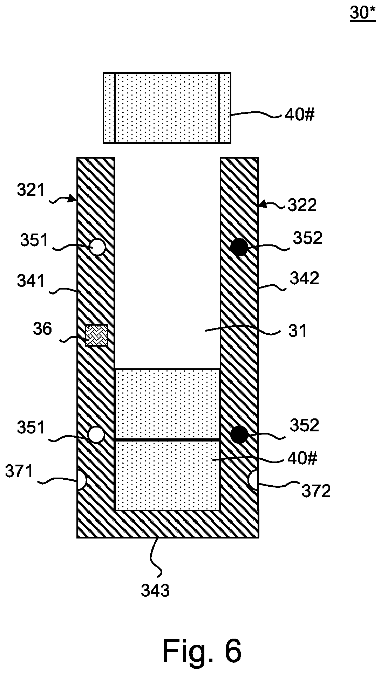

In der Figuren 6 ist der Aufbau einer alternativen Ausführungsform des insgesamt rahmenförmigen Trägerrahmens 30* detailliert gezeigt.

Der in Figur 6 gezeigte Trägerrahmen 30^{∗} unterscheidet sich von dem in Figur 5A gezeigten Trägerrahmen 30# insbesondere dadurch, dass er insgesamt eine U-Form aufweist und einstückig aus Kunststoff oder Metall gefertigt ist. Da der Trägerrahmen 30^{∗} zu einer Schmalseite hin offen ist, können die Kontaktträger 40# einfach von dieser Schmalseite aus eingeschoben werden, ohne dass es erforderlich ist, den Trägerrahmen 30^{∗} zuvor zu öffnen. Dies geht natürlich nicht mehr, wenn der Trägerrahmen 30^{∗} in den Aufnahmerahmen 10 eingeschoben und der Deckel 20 verschlossen ist.

Wird der Trägerrahmen 30^{∗} mit den von diesem aufgenommenen Kontaktträgern 40# durch Einschieben in eine Ausnehmung 12 des Aufnahmerahmens 10 eingesetzt und der Deckel 20 des Massenverbindungssystems 1 verschlossen, so setzen die Blattfedern 21 des Deckels 20 die in den Trägerrahmen 30^{∗} eingeschobenen Kontraktträger 40# unter Druck und verhindern so ein Herausrutschen der Kontraktträger 40# aus dem Trägerrahmen 30^{∗}.

Hinsichtlich der übrigen Merkmale des in Figur 6 gezeigten Trägerrahmens 30^{∗} wird auf die Ausführung zu dem in den Figuren 5A und 5B gezeigten Trägerrahmen 30# verwiesen.

Obwohl die voranstehenden Ausführungsbeispiele der vorliegenden Erfindung lediglich beispielhaft erläutert worden sind, werden die Fachleute erkennen, dass zahlreiche Modifikationen, Hinzufügungen und Ersetzungen möglich sind, ohne von dem Schutzbereich der in den nachfolgenden Ansprüchen offenbarten Erfindung abzuweichen.

## Patentansprüche

1. Massenverbindungssystem (1) für ein Testsystem, aufweisend:
einen Aufnahmerahmen (10); und
wenigstens einen Trägerrahmen (30, 30', 30", 30#, 30^{∗});
wobei der Aufnahmerahmen (10) mehrere Ausnehmungen (12) aufweist, welche den Aufnahmerahmen (10) in Dickenrichtung jeweils vollständig durchdringen und zu einer Einschubkante (11) des Aufnahmerahmens (10) hin jeweils offen sind, wobei jede Ausnehmung (12) zwei zueinander parallele Seitenwände (121, 122) festlegt, die mit der Einschubkante (11) jeweils einen Winkel von zwischen 60° und 120° und bevorzugt 90° einschließen,
wobei jeder Trägerrahmen (30, 30', 30", 30#, 30^{∗}) zwei zueinander parallele Seitenwände (131, 132) aufweist, welche dazu ausgebildet sind, mit den parallelen Seitenwänden (121, 122) einer jeden Ausnehmung (12) des Aufnahmerahmens (10) in Formschluss zu kommen, und
wobei wenigstens ein Trägerrahmen (30, 30', 30", 30#, 30*) weiter eine Öffnung (31) zur Aufnahme wenigstens eines Kontaktträgers (40, 40', 40#) aufweist, wobei alle Ausnehmungen (12) im Aufnahmerahmen (10) die gleiche Innenkontur aufweisen und
wobei alle Trägerrahmen (30, 30', 30", 30#, 30^{∗}) die gleiche Außenkontur aufweisen, wobei die Außenkontur aller Trägerrahmen (30, 30', 30", 30#, 30^{∗}) zumindest abschnittsweise zur Innenkontur aller Ausnehmungen (12) im Aufnahmerahmen (10) komplementär ist,
**dadurch gekennzeichnet, dass**
die Einschubkante des Aufnahmerahmens (10) eine Seitenkante des Aufnahmerahmens (10) ist, wodurch der wenigstens eine Trägerrahmen (30, 30', 30", 30#, 30^{∗}) zur Seite hin aus dem Aufnahmerahmen (10) entnommen werden kann, und
der wenigstens eine Trägerrahmen (30#) an wenigstens einer Schmalseite ein vom Trägerrahmen (30#) lösbares Element aufweist, welches es erlaubt, die Öffnung (31) des wenigstens einen Trägerrahmens (30#) zu einer Schmalseite des Trägerrahmens (30#) hin zu öffnen, und so ausgebildet ist, von der Schmalseite aus ein Einschieben wenigstens eines Kontaktträgers (40, 40', 40#) in die Öffnung (31) zu erlauben oder
die Öffnung (31) des wenigstens einen Trägerrahmens (30^{∗}) hin zu einer Schmalseite des Trägerrahmens (30#, 30^{∗}) offen und ausgebildet ist, von der Schmalseite aus ein Einschieben wenigstens eines Kontaktträgers (40, 40', 40#) in die Öffnung (31) zu erlauben.

2. Massenverbindungssystem (1) nach Anspruch 1 oder 2,
wobei einander gegenüberliegende und zueinander parallele die Öffnung (31) des wenigstens einen Trägerrahmens (30#, 30^{∗}) begrenzende Wände des Trägerrahmens (30#, 30^{∗}) ausgebildet sind, mit einer Außenkontur wenigstens eines in der Öffnung aufzunehmenden Kontaktträgers (40, 40', 40#) in Formschluss zu kommen.

3. Massenverbindungssystem (1) nach Anspruch 1 oder 2,
wobei wenigstens eine Seitenwand (121, 122) der zueinander parallelen Seitenwände (121, 122) jeder Ausnehmung (12) im Aufnahmerahmen (10) wenigstens einen Vorsprung aufweist und wobei wenigstens eine Seitenwand (131, 132) der zueinander parallelen Seitenwände (131, 132) jedes Trägerrahmens (30, 30', 30", 30#, 30^{∗}) wenigstens einen zum wenigstens einen Vorsprung komplementären Rücksprung aufweist; und/oder
wobei wenigstens eine Seitenwand (121, 122) der zueinander parallelen Seitenwände (121, 122) jeder Ausnehmung (12) im Aufnahmerahmen (10) wenigstens einen Rücksprung aufweist und wobei wenigstens eine Seitenwand (131, 132) der zueinander parallelen Seitenwände (131, 132) jedes Trägerrahmens (30, 30', 30", 30#, 30^{∗}) wenigstens einen zum wenigstens einen Rücksprung komplementären Vorsprung aufweist.

4. Massenverbindungssystem (1) nach Anspruch 1, 2 oder 3, wobei jeder Trägerrahmen (30, 30', 30", 30#, 30^{∗}) ausgebildet ist, eine jede der Ausnehmungen (12) im Aufnahmerahmen (10) zu 100 % oder zu 75 % oder zu 66 % oder zu 50 % oder zu 33 % oder zu 25 % auszufüllen.

5. Massenverbindungssystem (1) nach einem der Ansprüche 1 bis 4, wobei die beiden zueinander parallelen Seitenwände (121, 122) jeder Ausnehmung (12) und die beiden zueinander parallelen Seitenwände (131, 132) jedes Trägerrahmens (30, 30', 30", 30#, 30^{∗}) im Querschnitt voneinander paarweise unterschiedliche Konturen aufweisen.

6. Massenverbindungssystem (1) nach einem der Ansprüche 1 bis 5, wobei wenigstens ein Trägerrahmen (30#) einen Rahmen aus vier paarweise zueinander parallelen Körpern (341, 342, 343, 344) aufweist, welche die Seiten des Trägerrahmens (30#) bilden und die Öffnung (31) zur Aufnahme wenigstens eines Kontaktträgers (40, 40', 40#) festlegen,
wobei die Körper (341, 342), welche die Seiten des Trägerrahmens (30^{∗}) bilden, stabförmig ausgebildet sind, und die Körper (343, 344), welche die Oberseite und Unterseite des Trägerrahmens (30^{∗}) bilden, plattenförmig ausgebildet sind, und wobei die plattenförmigen Körper (343, 344) jeweils mit den beiden stabförmigen Körpern (341, 342) lösbar verbunden sind, wobei die beiden stabförmigen Körper (341, 342) an ihrer der Öffnung (31) zugewandten Seite optional jeweils eine Kontur aufweisen, die ausgebildet ist, mit einer Außenkontur wenigstens eines in der Öffnung aufzunehmenden Kontaktträgers (40, 40', 40#) in Formschluss zu kommen.

7. Massenverbindungssystem (1) nach einem der Ansprüche 1 bis 6, wobei der Aufnahmerahmen (10) und/oder wenigstens ein Trägerrahmen (30^{∗}) wenigstens zwei Zentriermittel aufweist.

8. Massenverbindungssystem (1) nach einem der Ansprüche 1 bis 7, weiter aufweisend einen Deckel (20), wobei der Deckel (20) ausgebildet ist, so an der Einschubkante (11) des Aufnahmerahmens (10) mit dem Aufnahmerahmen (10) verbunden zu werden, dass er die Ausnehmungen (12) im Aufnahmerahmen (10) und/oder die Öffnung (31) des wenigstens einen Trägerrahmens (30^{∗})verschließt.

9. Massenverbindungssystem (1) nach Anspruch 8, wobei der Deckel (20) eine der Anzahl an Ausnehmungen (12) im Aufnahmerahmen (10) entsprechende Anzahl an Federelementen (21) aufweist, wobei die Federelemente (21) voneinander den gleichen Abstand aufweisen, wie die Ausnehmungen (12) im Aufnahmerahmen (10), wobei die Federelemente (21) bei mit dem Aufnahmerahmen (10) verbundenem Deckel (20) optional jeweils mittig zu einer Ausnehmung (12) im Aufnahmerahmen (10) angeordnet sind.

10. Massenverbindungssystem (1) nach einem der Ansprüche 8 oder 9, wobei der Deckel (20) durch Verschrauben (23) oder mittels einer Schnappverbindung lösbar an dem Aufnahmerahmen (10) befestigbar ist.

11. Massenverbindungssystem (1) nach einem der Ansprüche 8 bis 10, weiter aufweisend ein Gehäuse, welches einseitig von dem Aufnahmerahmen (10) und dem Deckel (20) verschlossen ist, und eine Verdrahtung für wenigstens einen Kontaktträger (40, 40', 40#) aufnimmt.

12. Massenverbindungssystem (1) nach einem der Ansprüche 1 bis 11, wobei die Ausnehmungen (12) des Aufnahmerahmens (10) jeweils wenigstens ein Federelement (14) aufweisen, das ausgebildet ist, den wenigstens einen Trägerrahmen (30, 30', 30", 30#, 30^{∗}) lösbar innerhalb der dem jeweiligen Federelement (14) zugeordneten Ausnehmung (12) zu haltern.

13. Massenverbindungssystem (1) nach einem der Ansprüche 1 bis 12,
weiter aufweisend wenigstens einen Kontaktträger (40, 40', 40#),
wobei jeder Kontaktträger (40, 40', 40#) dazu ausgebildet ist, Leitungen für technische Medien zu verbinden oder zu trennen und insbesondere elektrische Leitungen zu Verbinden oder zu Trennen und/oder Leitungen für optische Strahlung zu verbinden oder zu trennen, wobei jeder Kontaktträger (40, 40', 40#) insbesondere ein Einbaustecker oder eine Buchse ist.

14. Massenverbindungssystem (1) nach einem der Ansprüche 1 bis 13, wobei jeder Trägerrahmen (30, 30', 30", 30#, 30^{∗}), der eine Öffnung (31) zur Aufnahme wenigstens einen Kontaktträgers (40, 40', 40#) aufweist, Befestigungsmittel (33) zur Halterung des jeweiligen Kontaktträgers (40, 40', 40#) aufweist.

15. Massenverbindungssystem (1) nach einem der Ansprüche 1 bis 14, wobei die Ausnehmungen (12) im Aufnahmerahmen (10) in regelmäßigen Abständen voneinander angeordnet sind.

## Claims

1. Mass connection system (1) for a test system, comprising:
a receiving frame (10); and
at least one carrier frame (30, 30', 30", 30#, 30^{∗});
wherein the receiving frame (10) has several recesses (12), which in each case completely penetrate the receiving frame (10) in the thickness direction and are in each case open towards an insertion edge (11) of the receiving frame (10), wherein each recess (12) defines two mutually parallel side walls (121, 122), which in each case enclose an angle of between 60° and 120° and preferably 90° with the insertion edge (11),
wherein each carrier frame (30, 30', 30", 30#, 30^{∗}) has two mutually parallel side walls (131, 132), which are designed to come into positive mechanical engagement with the parallel side walls (121, 122) of each recess (12) of the receiving frame (10), and
wherein at least one carrier frame (30, 30', 30", 30#, 30^{∗}) further has an opening (31) for holding at least one contact carrier (40, 40', 40#),
wherein all recesses (12) in the receiving frame (10) have the same inner contour, and
wherein all carrier frames (30, 30', 30', 30#, 30^{∗}) have the same outer contour, wherein the outer contour of all carrier frames (30, 30', 30", 30 #, 30^{∗}) is, at least in sections, complementary to the inner contour of all recesses (12) in the receiving frame (10),
**characterised in that**
the insertion edge of the receiving frame (10) is a side edge of the receiving frame (10), whereby the at least one carrier frame (30, 30', 30", 30 #, 30^{∗}) can be removed laterally from the receiving frame (10), and
whereby at least one carrier frame (30#) has, on at least one narrow side, an element which can be detached from the carrier frame (30#), which element allows the opening (31) of the at least one carrier frame (30#) to be opened towards a narrow side of the carrier frame (30#), and is designed to allow at least one contact carrier (40, 40', 40#) to be inserted into the opening (31) from the narrow side, or
whereby the opening (31) of the at least one carrier frame (30^{∗}) is open towards a narrow side of the carrier frame (30#, 30^{∗}) and designed to allow at least one contact carrier (40, 40', 40#) to be pushed into the opening (31) from the narrow side.

2. Mass connection system (1) according to Claim 1 or 2,
wherein mutually opposite and mutually parallel walls of the carrier frame (30#, 30^{∗}) delimiting the opening (31) of the at least one carrier frame (30#, 30^{∗}) are designed to come into positive mechanical engagement with an outer contour of at least one contact carrier (40, 40', 40#) to be received in the opening.

3. Mass connection system (1) according to Claim 1 or 2,
wherein at least one side wall (121, 122) of the mutually parallel side walls (121, 122) of each recess (12) in the receiving frame (10) has at least one projection, and wherein at least one side wall (131, 132) of the mutually parallel side walls (131, 132) of each carrier frame (30, 30', 30", 30#, 30^{∗}) has at least one groove complementary to the at least one projection; and/or
wherein at least one side wall (121, 122) of the mutually parallel side walls (121, 122) of each recess (12) in the receiving frame (10) has at least one recess, and wherein at least one side wall (131, 132) of the mutually parallel side walls (131, 132) of each carrier frame (30, 30', 30", 30#, 30^{∗}) has at least one projection complementary to the at least one groove.

4. Mass connection system (1) according to Claim 1, 2 or 3, wherein each carrier frame (30, 30', 30 ", 30 #, 30^{∗}) is designed to fill each of the recesses (12) in the receiving frame (10) to 100% or 75% or carrier frame (30, 30', 30", 30#, 30^{∗}) have mutually different contours in pairs cross-section.

5. Mass connection system (1) according to any one of claims 1 to 4, wherein the two mutually parallel side walls (121, 122) of each recess (12) and the two parallel to each other parallel side walls (131, 132) each carrier frame (30, 30', 30", 30#, 30^{∗}) have contours that differ in cross-section from one another in pairs.

6. Mass connection system (1) according to one of Claims 1 to 5, wherein at least one carrier frame (30#) has a frame of four bodies (341, 342, 343, 344) which are parallel to one another in pairs and form the sides of the carrier frame (30#) and define the opening (31) for holding at least one contact carrier (40, 40', 40#),
wherein the bodies (341, 342), which form the sides of the carrier frame (30^{∗}), have a rod-shaped design, and the bodies (343, 344), which form the upper side and underside of the carrier frame (30^{∗}), have a plate-shaped design, and wherein the plate-shaped bodies (343, 344) are each detachably connected to the two rod-shaped bodies (341, 342), wherein the two rod-shaped bodies (341, 342), on their side facing the opening (31), optionally each have a contour which is designed to come into positive mechanical engagement with an outer contour of at least one body (343, 344) to be received in the opening of the contact carrier (40, 40', 40#).

7. Mass connection system (1) according to one of Claims 1 to 6, wherein the receiving frame (10) and/or at least one carrier frame (30^{∗}) has at least two centring means.

8. Mass connection system (1) according to one of Claims 1 to 7, further comprising a cover (20), wherein the cover (20) is designed to be connected to the receiving frame (10) at the insertion edge (11) of the receiving frame (10) such that it closes the recesses (12) in the receiving frame (10) and/or the opening (31) of the at least one carrier frame (30^{∗}).

9. Mass connection system (1) according to Claim 8, wherein the cover (20) has a number of spring elements (21) corresponding to the number of recesses (12) in the receiving frame (10), the spring elements (21) being at the same distance from one another as the recesses (12) in the receiving frame (10), the spring elements (21) optionally being arranged in each case centrally with respect to a recess (12) in the receiving frame (10) when the cover (20) is connected to the receiving frame (10).

10. Mass connection system (1) according to one of claims 8 or 9, wherein the cover (20) can be detachably fastened to the receiving frame (10) by screwing (23) or by means of a snap connection.

11. Mass connection system (1) according to any one of Claims 8 to 10, further comprising a housing closed on one side by the receiving frame (10) and the cover (20) and receiving wiring for at least one contact carrier (40, 40', 40#).

12. Mass connection system (1) according to one of Claims 1 to 11, wherein the recesses (12) of the receiving frame (10) each have at least one spring element (14) which is designed to detachably secure the at least one carrier frame (30, 30', 30", 30 #, 30^{∗}) within the recess (12) assigned to the respective spring element (14).

13. Mass connection system (1) according to one of Claims 1 to 12, further comprising at least one contact carrier (40, 40', 40 #),
wherein each contact carrier (40, 40', 40#) is designed to connect or separate lines for technical media and in particular to connect or separate or separate electrical lines and/or lines for optical radiation, wherein each contact carrier (40, 40', 40#) is in particular a built-in plug or a socket.

14. Mass connection system (1) according to one of Claims 1 to 13, in which each carrier frame (30, 30', 30", 30#, 30^{∗}), which has an opening (31) for holding at least one contact carrier (40, 40', 40#), has fastening means (33) for holding the respective contact carrier (40, 40', 40#).

15. The mass connection system (1) according to any one of Claims 1 to 14, wherein the recesses (12) in the receiving frame (10) are arranged at regular intervals from one another.

## Revendications

1. Système de connexion de masse (1) pour un système de test, comprenant:
un cadre de réception (10) ; et
au moins un cadre de support (30, 30', 30", 30#, 30^{∗}) ;
où le cadre de réception (10) présente plusieurs évidements (12) qui traversent complètement le cadre de réception (10) dans le sens de l'épaisseur et qui sont ouverts vers un bord d'insertion (11) du cadre de réception (10), chaque évidement (12) définissant deux parois latérales (121, 122) parallèles l'une à l'autre qui forment avec le bord d'insertion (11) un angle compris entre 60° et 120° et de préférence de 90°,
où chaque cadre de support (30, 30', 30", 30#, 30^{∗}) présente deux parois latérales (131, 132) parallèles l'une à l'autre, qui sont conçues pour venir en complémentarité de forme avec les parois latérales parallèles (121, 122) de chaque évidement (12) du cadre de réception (10), et
où au moins un cadre de support (30, 30', 30", 30#, 30^{∗}) présente en outre une ouverture (31) pour loger au moins un support de contact (40, 40', 40#), tous les évidements (12) dans le cadre de réception (10) présentant le même contour intérieur et
où tous les cadres de support (30, 30', 30", 30#, 30^{∗}) présentant le même contour extérieur, le contour extérieur de tous les cadres de support (30, 30', 30", 30#, 30^{∗}) étant complémentaire, au moins par sections, au contour intérieur de tous les évidements (12) dans le cadre de réception (10),
**caractérisé par le fait que**
le bord d'insertion du cadre de réception (10) est un bord latéral du cadre de réception (10), moyennant quoi au moins un cadre de support (30, 30', 30", 30#, 30^{∗}) peut être retiré du cadre de réception (10) vers le côté, et
au moins un cadre de support (30#) présente, sur au moins un côté étroit, un élément détachable du cadre de support (30#) qui permet d'ouvrir l'ouverture (31) d'au moins un cadre de support (30#) vers un côté étroit du cadre de support (30#), et est conçu de manière à permettre, à partir du côté étroit, l'insertion d'au moins un support de contact (40, 40', 40#) dans l'ouverture (31) ou
l'ouverture (31) d'au moins un cadre de support (30^{∗}) est ouverte vers un côté étroit du cadre de support (30#, 30^{∗}) et est conçue pour permettre l'insertion d'au moins un support de contact (40, 40', 40 #) dans l'ouverture (31) à partir du côté étroit.

2. Système de connexion de masse (1) selon la revendication 1 ou 2, dans lequel des parois du cadre de support (30#, 30^{∗}) opposées l'une à l'autre et parallèles entre elles, délimitant l'ouverture (31) d'au moins un cadre de support (30#, 30^{∗}), sont conçues pour venir en complémentarité de forme avec un contour extérieur d'au moins un support de contact (40, 40', 40#) à loger dans l'ouverture.

3. Système de connexion de masse (1) selon la revendication 1 ou 2,
dans lequel au moins une paroi latérale (121, 122) des parois latérales parallèles (121, 122) de chaque évidement (12) dans le cadre de réception (10) présente au moins une saillie et dans lequel au moins une paroi latérale (131, 132) des parois latérales parallèles (131, 132) de chaque cadre de support (30, 30', 30", 30#, 30^{∗}) présente au moins un retrait complémentaire à au moins une saillie;
et/ou dans lequel au moins une paroi latérale (121, 122) des parois latérales (121, 122) parallèles entre elles de chaque évidement (12) dans le cadre de réception (10) présente au moins un retrait et dans lequel au moins une paroi latérale (131, 132) des parois latérales (131, 132) parallèles entre elles de chaque cadre de support (30, 30', 30", 30#, 30^{∗}) présente au moins une saillie complémentaire à au moins un retrait.

4. Système de connexion de masse (1) selon la revendication 1, 2 ou 3, dans lequel chaque cadre de support (30, 30', 30", 30#, 30^{∗}) est conçu pour remplir chacun des évidements (12) dans le cadre de réception (10) à 100 %, 75 %, 66 %, 50 %, 33 % ou 25 %.

5. Système de connexion de masse (1) selon l'une des revendications 1 à 4, dans lequel les deux parois latérales (121, 122) parallèles entre elles de chaque évidement (12) et les deux parois latérales (131, 132) parallèles entre elles de chaque cadre de support (30, 30', 30", 30#, 30^{∗}) présentent en section transversale des contours différents les unes des autres par paires.

6. Le système de connexion de masse (1) selon n'importe laquelle des revendications 1 à 5, dans lequel au moins un cadre de support (30#) comprend un cadre de quatre corps (341, 342, 343, 344) parallèles deux à deux, qui forment les côtés du cadre de support (30#) et définissent l'ouverture (31) pour recevoir au moins un support de contact (40, 40', 40#),
les corps (341, 342) qui forment les côtés du cadre de support (30^{∗}) étant en forme de barre et les corps (343, 344), qui forment le côté supérieur et le côté inférieur du cadre de support (30^{∗}), sont réalisés en forme de plaque, et les corps en forme de plaque (343, 344) étant respectivement reliés de manière amovible aux deux corps en forme de tige (341, 342), les deux corps en forme de tige (341, 342) présentant en option sur leur côté tourné vers l'ouverture (31) respectivement un contour qui est réalisé de manière à venir en complémentarité de forme avec un contour extérieur d'au moins un support de contact (40, 40', 40#) à loger dans l'ouverture.

7. Système de connexion de masse (1) selon l'une des revendications 1 à 6, dans lequel le cadre de réception (10) et/ou au moins un cadre de support (30^{∗}) comprend au moins deux moyens de centrage.

8. Système de connexion de masse (1) selon l'une des revendications 1 à 7, comprenant en outre un couvercle (20), le couvercle (20) étant conçu pour être connecté au cadre de réception (10) au niveau du bord d'insertion (11) du cadre de réception (10) de manière à fermer les évidements (12) dans le cadre de réception (10) et/ou l'ouverture (31) d'au moins un cadre de support (30^{∗}).

9. Système de connexion de masse (1) selon la revendication 8, dans lequel le couvercle (20) présente un nombre d'éléments de ressort (21) correspondant au nombre d'évidements (12) dans le cadre de réception (10), les éléments de ressort (21) présentant entre eux la même distance que les évidements (12) dans le cadre de réception (10), les éléments de ressort (21) étant disposés en option, lorsque le couvercle (20) est relié au cadre de réception (10), respectivement au centre d'un évidement (12) dans le cadre de réception (10).

10. Système de connexion de masse (1) selon l'une des revendications 8 ou 9, dans lequel le couvercle (20) peut être fixé de manière amovible au cadre de réception (10) par vissage (23) ou par une connexion par encliquetage.

11. Système de connexion de masse (1) selon l'une des revendications 8 à 10, comprenant en outre un boîtier qui est fermé d'un côté par le cadre de réception (10) et le couvercle (20) et qui reçoit un câblage pour au moins un support de contact (40, 40', 40#).

12. Système de connexion de masse (1) selon l'une des revendications 1 à 11, dans lequel les évidements (12) du cadre de réception (10) présentent chacun au moins un élément de ressort (14) qui est conçu pour maintenir de manière amovible au moins un cadre de support (30, 30', 30 ", 30 #, 30^{∗}) à l'intérieur de l'évidement (12) associé à l'élément de ressort respectif (14).

13. Système de connexion de masse (1) selon l'une des revendications 1 à 12, présentant en outre au moins un support de contact (40, 40', 40#),
chaque support de contact (40, 40', 40#) étant conçu pour connecter ou déconnecter des lignes de fluides techniques et en particulier pour connecter ou déconnecter des lignes électriques et/ou pour connecter ou déconnecter des lignes pour un rayonnement optique, chaque support de contact (40, 40', 40#) étant en particulier une fiche encastrable ou une douille.

14. Système de connexion de masse (1) selon l'une des revendications 1 à 13, dans lequel chaque cadre de support (30, 30', 30 ", 30 #, 30^{∗}) présentant une ouverture (31) pour loger au moins un support de contact (40, 40', 40#) et des moyens de fixation (33) pour maintenir le support de contact respectif (40, 40', 40#).

15. Système de connexion de masse (1) selon l'une des revendications 1 à 14, dans lequel les évidements (12) sont disposés dans le cadre de réception (10) à des intervalles réguliers les uns des autres.
